Europäisches Patentamt

European Patent Office

Office européen des brevets

(11) Numéro de publication : **0 431 435 B1**

(12) **FASCICULE DE BREVET EUROPEEN**

(19)

(45) Date de publication du fascicule du brevet :
**15.03.95 Bulletin 95/11**

(21) Numéro de dépôt : **90122516.9**

(22) Date de dépôt : **26.11.90**

(51) Int. Cl.⁶ : **H03G 3/20**

(54) **Dispositif de commande automatique de gain pour demodulateur equipant un recepteur pour installation de transmission numerique d'informations.**

(30) Priorité : **30.11.89 FR 8915806**

(43) Date de publication de la demande :
**12.06.91 Bulletin 91/24**

(45) Mention de la délivrance du brevet :
**15.03.95 Bulletin 95/11**

(84) Etats contractants désignés :
**DE ES FR GB IT NL SE**

(56) Documents cités :
**EP-A- 0 025 607**
**EP-A- 0 213 224**
**DE-A- 3 206 114**

(56) Documents cités :
**E.D.N. ELECTRICAL DESIGN NEWS, vol. 32,
no. 2, 22 janvier 1987, pages 181-183,186-187,
Newton, MA, US; A. KANIEL: "Flexible PGA
designs require few components"**

(73) Titulaire : **ALCATEL TELSPACE**
**5, rue Noel Pons**
**F-92734 Nanterre Cédex (FR)**

(72) Inventeur : **Gressier, Alain**
**116, rue Danton**
**F-92300 Levallois Perret (FR)**

(74) Mandataire : **Weinmiller, Jürgen et al**
**Lennéstrasse 9**
**Postfach 24**
**D-82336 Feldafing (DE)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention se rapporte à un dispositif de commande automatique de gain pour démodulateur équipant un récepteur pour installation de transmission numérique d'informations.

Les dispositifs de Commande Automatique de Gain, ou "CAG", sont couramment employés dans les récepteurs pour transmissions numériques par faisceau hertzien. Ils ont pour objet de maintenir le niveau du signal à une valeur constante à l'aide d'une boucle d'asservissement, dite "bouche de CAG", cette valeur constante du signal étant en particulier nécessitée à l'entrée du démodulateur pour permettre à ce dernier de fonctionner correctement.

Généralement, un premier dispositif de CAG est prévu dans la chaîne en Fréquence Intermédiaire, où il assure une grande dynamique, et un second dispositif de CAG est prévu à l'entrée du démodulateur, où il assure une correction complémentaire de petite dynamique, utile au cas où un brouilleur se glisserait entre les gabarits du filtre agile réception et du filtre étroit (généralement constitué par un filtre à ondes de surface) placé à l'entrée du démodulateur : c'est ce second dispositif de CAG qui est concerné par la présente invention.

Dans les systèmes classiques, le dispositif de CAG qui est placé directement à l'entrée du démodulateur fonctionne de la façon suivante :

Le signal démodulé que l'on obtient sur une des voies, ou "oeil", est amplifié, puis appliqué à un détecteur suivi d'un filtre, afin d'en extraire la composante continue représentant l'amplitude A du signal démodulé. Ce signal filtré est, le cas échéant, inversé, puis il est appliqué à l'entrée de commande d'un atténuateur réglable (généralement constitué par un atténuateur à diodes PIN) qui est situé en Fréquence Intermédiaire juste avant le démodulateur.

Ces dispositifs connus présentent deux inconvénients majeurs :
- la détection fait appel à des diodes dont le seuil de détection non nul dégrade la linéarité du dispositif, c'est à dire la linéarité de la tension de CAG obtenue en fonction de l'amplitude A de la tension détectée;
- le signal démodulé présente, dans son spectre, des composantes basse-fréquence difficiles à filtrer si l'on veut préserver une bande de boucle suffisamment large : ces composantes basse-fréquence se retrouvent sur la tension de CAG et altèrent le fonctionnement du dispositif.

L'invention vise à remédier à ces inconvénients. Elle se rapporte à cet effet à un dispositif de Commande Automatique de Gain (CAG) destiné à être placé à l'entrée du démodulateur équipant un récepteur pour installation de transmission numérique d'informations, ce dispositif de CAG comportant :
. des moyens pour convertir le signal analogique démodulé obtenu sur une des voies de sortie du démodulateur en signal numérique échantillonné au rythme de l'horloge-bit du signal numérique reçu par le récepteur ;
. des moyens pour ensuite additionner numériquement à chaque fois les valeurs absolues des signaux numériques relatifs à deux échantillons consécutifs ;
. des moyens pour déterminer alors la valeur moyenne, obtenue sur au moins plusieurs dizaines d'additions précitées successives, du résultat obtenu pour chacune de ces additions, et pour utiliser cette valeur moyenne pour commander un dispositif réglable d'atténuation de tension prévu a l'entrée du démodulateur.

De toute façon, l'invention sera bien comprise, et ses avantages et autres caractéristiques ressortiront, lors de la description suivante de deux exemples non limitatifs de réalisation, en référence au dessin schématique annexé dans lequel :
- Figure 1 est un schéma synoptique d'une première forme de réalisation de ce dispositif de Commande Automatique de Gain ; et
- Figure 2 est un schéma synoptique partiel d'une deuxième forme de réalisation de ce dispositif de Commande Automatique de Gain.

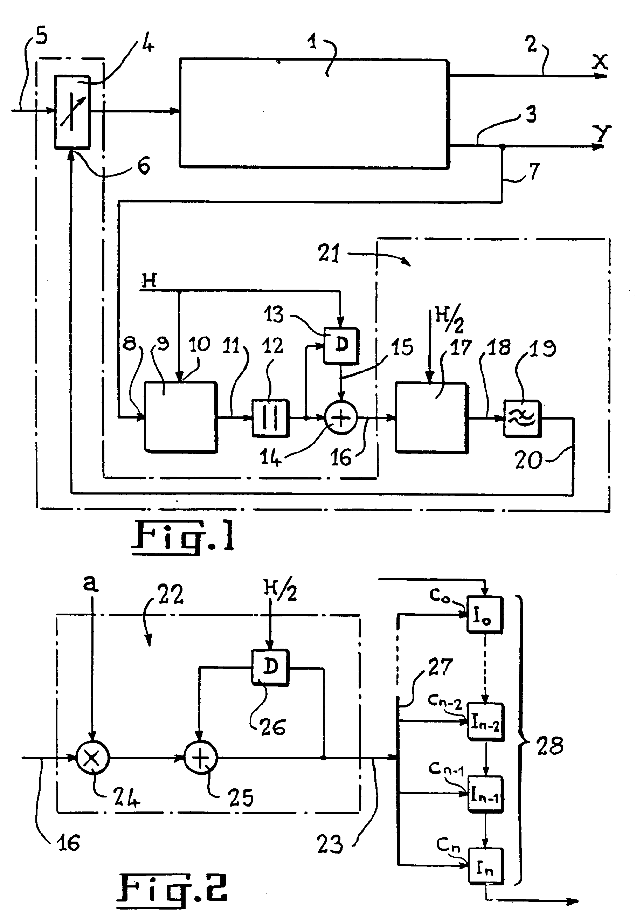

En se référant à la figure 1, la référence 1 désigne le démodulateur d'un récepteur d'installation de transmission numérique par faisceau hertzien utilisant une modulation de type $MAQ2^n$, et dans cet exemple précis une modulation MAQ4, à donc quatre états de phase.

Les signaux démodulés X et Y, ou "yeux", apparaissent respectivement sur les deux voies de sortie 2 et 3 du démodulateur 1.

De manière classique, un atténuateur analogique réglable est placé a l'entrée du démodulateur 1, en série avec le signal incident en 5, et il voit son entrée de commande d'atténuation 6 reliée à la sortie d'un circuit de régulation, dont l'entrée 7 est constituée par le signal démodulé pris sur un des "yeux" et dans cet exemple sur l'oeil Y, et qui sera décrit maintenant.

Le signal démodulé sur l'oeil Y, dont l'amplitude absolue sera désignée ci-après par A, est appliqué à l'entrée 8 d'un convertisseur Analogique-Numérique 9 qui est échantillonné en 10 au rythme de l'horloge-bit H. Les valeurs numériques échantillonnées qui en sont ainsi extraites en 11 sont passées dans un circuit logique 12 apte à calculer la valeur absolue de chacun de ces échantillons successifs.

Ces valeurs absolues d'échantillons successifs sont alors appliquées à la fois à une bascule "D", échantillonnée elle-aussi au rythme de l'horloge-bit H, et à la première entrée d'un additionneur numérique 14 qui reçoit sur son autre entrée la sortie 15 de cette bascule "D" 13 : le signal numérique sur la sortie 16 de cet additionneur 14 est donc constitué à chaque fois par la somme des valeurs absolues de deux échantillons successifs apparaissant sur la sortie 11 du convertisseur Analogique-Numérique 9. En supposant cet échantillonnage précis (ce qui, comme on le verra par la suite, n'est en réalité pas nécessaire), le signal en 16 aura donc pour valeur :

$$|\pm A| + o = A$$

en cas de transition,

et pour valeur :

$$|\pm A| + |A| = 2A$$

dans le cas où il n'y a pas transition.

Les bits se succèdent de façon aléatoire, les probabilités d'obtention des valeurs A et 2A en 16 sont égales, et par suite la valeur numérique moyenne obtenue en 16 sur un nombre suffisant (au moins plusieurs dizaines) d'échantillons successifs est approximativement égale à 3A/2 : c'est la traduction analogique de cette valeur qu'il convient alors d'appliquer sur la commande 6 de l'atténuateur-série 4.

Dans ce but, les signaux en 16 sont appliqués à un convertisseur Numérique-Analogique 17, échantillonné au rythme H/2 afin de prendre en compte par paires les échantillons successifs précités (H étant l'horloge-bit). Le signal analogique qui en sort en 18 est appliqué à un filtre de lissage (filtre passe-bas) 19 apte à réaliser une intégration valable sur au moins plusieurs dizaines de signaux successifs : il en sort en 20 un signal analogique d'amplitude sensiblement égale à 3A/2, et inversé grâce à un inverseur compris dans le filtre 19 (ce qui est par exemple réalisé par la classique utilisation d'un amplificateur opérationnel pour ce filtre), et c'est ce signal qui est appliqué sur l'entrée de commande 6 de l'atténuateur 4 afin de réaliser la Commande Automatique de Gain désirée.

Une variante intéressante de réalisation du bloc 21, entouré en traits mixtes sur la figure 1, est représentée à la figure 2.

Dans ce cas, les valeurs numériques successives des valeurs absolues de deux échantillons successifs, qui sont obtenues en 16 en sortie de l'additionneur 14 de la figure 1, ne sont pas converties en signaux analogiques, mais sont appliquées à un circuit disponible dans le commerce sous l'appellation 'ADSP", qui est un accumulateur numérique jouant, en numérique, exactement le même rôle qu'une capacité d'accumulation en analogique. Plus précisément, un tel circuit fournit, pour chaque signal numérique $e_k$ qui lui est appliqué à son entrée 16 à l'instant d'échantillonnage k, un signal de sortie en 23 égal à :

$$S_k = S_{k-1} + a.e_k$$

où "a" est un coefficient de filtrage et $S_{k-1}$ est le signal de sortie qu'il avait fourni à l'instant d'échantillonnage précédent (k-1).

Ce circuit 22 comporte très simplement un multiplicateur 24 recevant le coefficient a et le signal d'entrée, suivi d'un sommateur 25 qui reçoit également sa propre sortie 23 passée par une bascule "D" 26 échantillonnée au rythme H/2, moitié de celui de l'horloge-bit H.

Les signaux numériques ainsi calculés en 23 sont sortis en parallèle en 27, de telle sorte que leurs bits constitutifs, du bit de poids le plus faible à celui de poids le plus fort, sont respectivement appliqués aux entrées de commande d'activation ou de non-activation Co, .. .Cn-2, Cn-1, Cn, d'une cascade 28 d'atténuateurs Io, . ..In-2, In-1, In, qui sont commandables par tout-ou-rien sur ces entrées de commande respectives Co à Cn, et dont les atténuations varient, de Io à In, comme les poids binaires successifs des bits qui leurs sont respectivement associés.

Le calcul suivant a pour objet de démontrer l'indépendance de fonctionnement du dispositif de l'invention de l'instant d'échantillonnage, et la qualité de sa linéarité. Les transitions de l'oeil sont approximées par un arc de sinusoïde.

On néglige l'influence de l'interférence intersymboles, qui du point de vue du dispositif envisagé, agit de même façon que du bruit ; ce terme disparait après filtrage de la tension détectée.

Dans le cas de la modulation MAQ4, la tension détectée peut s'écrire :

$$v(\tau) = \Sigma_{i,j} p_{i,j} . Vp_{i,j}(\tau)$$
$$= p_{1,1} . Vp_{1,1}(\tau) + p_{-1,-1} . Vp_{-1,-1}(\tau) + Vp_{-1,1}(\tau)$$
$$+ p_{-1,1} . Vp_{1,-1}(\tau) = 1/2 . (Vp_{1,1}(\tau) + Vp_{1,-1}(\tau))$$
$$= 1/2 . (Vp_1(\tau) + Vp_2(\tau))$$

où

$\tau$      est l'instant d'échantillonnage ($\tau \in [0,T/2]$)

$p_{i,j}$      sont les probabilités de transition de l'état i à l'état j sur deux bits successifs

$Vp_{i,j}$     est la tension correspondante résultante

T     est la durée d'un symbole

A     est l'amplitude de l'oeil

On en déduit :

- cas de deux bits successifs égaux : $Vp_1(\tau) = |\pm A| + |\pm A| = 2.A$

- cas d'une transition

$$Vp_2(\tau) = A.|\cos(\pi/T.(\tau + kT/2))| + A.|\cos(\pi/T.(\tau + (k+1).T/2))|$$
$$= A.|\cos(k\pi/2 + \tau\pi/T)| + A.|\cos((k+1).\pi/2 + \tau\pi/T)| \quad (1)$$

Lorsque k est pair (K=2n), il vient :

$$Vp_2(\tau) = A.|\cos(n\pi + \tau\pi/T)| + A.|\cos(n\pi + \pi/2 + \tau\pi/T)|$$
$$= A.\cos\pi/T - A.\cos(\pi/2 + \tau\pi T/) = 2.A.\sin(\pi/4)$$
$$.\sin(\pi/4 + 2\tau\pi/T)$$
$$= A\sqrt{2}.\sin(\pi/4 + \tau\pi T) \quad (2)$$

Lorsque k est impair, le résultat est identique en permutant les deux termes de l'expression (1).

$$v(\tau) = A + A.\sqrt{2}/2.\sin(\pi/4 + \tau\pi/T) = A.(1 + \sqrt{2}/2.\sin(\pi/4 + \tau\pi/T)$$

et, par exemple pour les deux valeurs extrêmes possibles de $\tau$

$$v(0) = v(T/2) = A.(1.\sqrt{2}/2.\sqrt{2}/2) = 1,5A$$

et

$$v(T/4) = A.(1 + \sqrt{2}/2) = 1,71A$$

On s'aperçoit finalement que l'expression de V varie très peu en fonction de $\tau$ et que par suite, un décalage, malencontreux ou non, de l'instant d'échantillonnage n'a aucune influence sur le fonctionnement du dispositif.

Ce résultat reste valable pour des modulations plus complexes que la modulation MAQ4. A titre d'exemple, et en utilisant, pour une modulation MAQ16 les mêmes notations que précédemment, il vient :

$$v(\tau) = \Sigma_{i,j}p_{i,j}.Vp_{i,j} = 2/16.(Vp_{3,3}(\tau) + Vp_{1,1}(\tau) + Vp_{3,1}(\tau) + Vp_{-3,-1}(\tau) + Vp_{1,-1}(\tau) + Vp_{1,-3}(\tau) + Vp_{3,-3}(\tau)$$
$$+ Vp_{-1,3}(\tau))$$

compte tenu de : $Vp_{i,j} = Vp_{j,i}$   $Vp_{-i,-j} = Vp_{i,j}$   $p_{i,j} = 1/16$

pour tout i et j éléments de {-3;-1;1;3}

Posons : $k\pi/2 + \tau\pi/T = \alpha$ et $(k+1)\pi/2 + \tau\pi/T = \beta$

$$Vp_{3,3}(\tau) + Vp_{1,1}(\tau) = 2.|A| + 2/3.|A| = 2.A + 2A/3$$
$$Vp_{3,-3}(\tau) + Vp_{1,-1}(\tau) = (A + A/3)(|\cos\alpha| + |\cos\beta|$$
$$Vp_{1,-3}(\tau) + Vp_{-1,3}(\tau) = A/3 + 2A/3.(|\cos\alpha| + |\cos\beta|)$$
$$Vp_{3,1}(\tau) + Vp_{-3,-1}(\tau) = 2A/3 + A/3.(|\cos\alpha| + |\cos\beta|)$$

avec $(|\cos\alpha| + |\cos\beta|) = \sqrt{2}.\sin(\pi/4 + \tau\pi/T) = \sqrt{2}.\sin\Phi$ d'après (2)

$$v(\tau) = 2/16.A/3.(4.(2 + \sqrt{2}.\sin\Phi) + 1 + 2\sqrt{2}.\sin\Phi + 2 + \sqrt{2}.\sin\Phi)$$
$$= A/24.(11 + 7.\sqrt{2}.\sin\Phi)$$

et par exemple pour les deux valeurs extrêmes possibles de $\tau$ :

$$v(0) = v(T/2) = A/24.(11 + 7) = 0,75A$$

et

$$v(T/4) = A/24.(11 + 7.\sqrt{2}) = 0,87A$$

Là aussi, l'expression de V ne varie pratiquement pas en fonction de $\tau$, de sorte que le dispositif d'échantillonnage utilisé peut être simple, voire même rustique.

Cette propriété très avantageuse peut se comprendre plus simplement par le fait qu'en cas de décalage de l'échantillonnage entraînant par exemple, pour une valeur d'amplitude maximale (normalement A), une baisse de tension égale à $\varepsilon$, la tension échantillonnée au coup suivant n'est alors pas égale à 0, en valeur absolue, mais à $\varepsilon$, en raison du décalage C mais de la périodicité constante de l'échantillonnage : l'amplitude du signal finalement obtenue lors de l'addition des valeurs absolues de ces deux échantillons successifs reste alors finalement bien égale à A.

Finalement, le dispositif de l'invention comporte les avantages suivants :

- indépendance pratique vis-à-vis du débit, ce dernier n'altérant pas le caractère aléatoire des symboles successifs ;
- absence pratique de seuil, ce dernier étant réduit à celui engendré par le débit de poids le plus faible (ou "LSB") ;
- indépendance pratique vis-à-vis de l'instant d'échantillonnage ;
- absence de perturbations par les composantes basse-fréquence de l'oeil, sans contraintes sur la bande de boucle.

En outre, et en particulier dans le cas de la variante plus numérisée de la figure 2, il se prête bien à une intégration dans un circuit prédiffusé, d'où diminution de coût et d'encombrement.

Enfin, dans le cas de la variante "numérisée" de la figure 2, il est très avantageusement possible d'obtenir directement sans réglage et grâce au codage du signal numérique de commande des atténuateurs en cascade, la valeur de la tension de CAG linéarisée, qui est une information dont on a besoin pour tester l'état du canal de transmission numérique.

Comme il va de soi, l'invention n'est pas limitée aux deux exemples de réalisation qui viennent d'être décrit, mais elle est bien au contraire susceptible d'être mise en oeuvre sous d'autres formes équivalentes, concernant éventuellement d'autres types de modulation.

## Revendications

1. Dispositif de Commande Automatique de Gain (CAG) destiné à être placé à l'entrée du démodulateur (1) équipant un récepteur pour installation de transmission numérique d'informations, caractérisé en ce qu'il comporte
   . des premiers moyens (9) pour convertir le signal analogique démodulé (Y) obtenu sur une des voies de sortie (3) du démodulateur (1) en signal numérique échantillonné au rythme de l'horloge-bit (H) du signal numérique reçu par le récepteur ;
   . des seconds moyens (12, 13, 14) pour ensuite additionner numériquement à chaque fois les valeurs absolues des signaux numériques relatifs à deux échantillons consécutifs ;
   . des troisièmes moyens (17 à 19, 22 à 27) pour déterminer alors la valeur moyenne (3A/2) obtenue sur au moins plusieurs dizaines d'additions précitées successives, du résultat (A ou 2A) obtenu pour chacune de ces additions, et pour utiliser cette valeur moyenne (3A/2) pour commander un dispositif réglable d'atténuation de tension (28) prévu à l'entrée du démodulateur (1).

2. Dispositif de CAG selon la revendication 1, caractérisé en ce que ces troisièmes moyens comportent un convertisseur Numérique-Analogique (17) et un filtre de lissage (19).

3. Dispositif de CAG selon la revendication 1, caractérisé en ce que ces troisièmes moyens comportent un multiplieur-accumulateur numérique (22) et une cascade (28) d'atténuateurs commandés en tout-ou-rien par les bits respectifs de chaque signal numérique sortant de ce multiplieur-accumulateur (22).

4. Dispositif de CAG selon la revendication 3, caractérisé en ce que les atténuations des atténuateurs de la cascade (28) varient (de Io à In) comme les poids binaires respectifs des bits qui leurs sont respectivement associés.

## Patentansprüche

1. Vorrichtung zur automatischen Verstärkungssteuerung (AGC), die am Eingang des Demodulators (1) eines Empfängers einer digitalen Datenübertragungsanlage liegen soll, dadurch gekennzeichnet, daß die Vorrichtung enthält
   . erste Mittel (9), die das auf einem der Ausgangskanäle (3) des Demodulators (1) erhaltene und demodulierte Analogsignal in ein im Rhythmus des Bittakts (H) des vom Empfänger empfangenen digitalen Signals getastetes digitales Signal umwandeln,
   . zweite Mittel (12, 13, 14), die dann jedesmal die Absolutwerte der digitalen Signale betreffend zwei aufeinanderfolgende Tastproben addieren,
   . dritte Mittel (17 bis 19, 22 bis 27), um dann den Mittelwert (3A/2) über mindestens mehrere zig aufeinanderfolgende Additionen des für jede dieser Additionen erhaltenen Ergebnisses (A oder 2A) zu bestimmen und um diesen Mittelwert (3A/2) zur Steuerung einer regelbaren Spannungs-Dämpfungsvorrichtung (28) zu verwenden, die am Eingang des Demodulators (1) vorgesehen ist.

2. AGC-Vorrichtung nach Anspruch 1, dadurch gekennzeichnet, daß die dritten Mittel einen Digital-Analog-Wandler (17) und ein Glättungsfilter (19) enthalten.

3. AGC-Vorrichtung nach Anspruch 1, dadurch gekennzeichnet, daß diese dritten Mittel einen digitalen Multiplizier-Akkumulator (22) und eine Kaskade (28) von durch die jeweiligen Bits jedes digitalen Signals am Ausgang des Multiplizier-Akkumulators (22) binär gesteuerten Dämpfungsglieder aufweisen.

4. AGC-Vorrichtung nach Anspruch 1, dadurch gekennzeichnet, daß die Dämpfungswirkungen der Dämpfungsglieder der Kaskade (28) wie die jeweiligen binären Gewichte (von Io bis In) der ihnen zugeordneten Bits variieren.

## Claims

1. Automatic Gain Control (AGC) device adapted to be disposed at the input of the demodulator (1) of a receiver for a digital information transmission installation, characterised in that it comprises
   . first means (9) for converting the demodulated analogue signal (Y) obtained on one output path (3) of the demodulator (1) into a digital signal sampled at the bit clock rate (H) of the digital signal received by the receiver;
   . second means (12, 13, 14) for then adding the absolute values of the digital signals relating to two consecutive samples in the digital domain;
   . third means (17 to 19, 22 to 27) for then determining the mean value (3A/2) over at least several tens of successive additions as above of the result (A or 2A) obtained for each such addition and for using this mean value (3A/2) to control a variable voltage attenuator device (28) disposed at the input of the demodulator (1).

2. AGC device according to claim 1 characterised in that said third means include a digital-to-analogue converter (17) and a smoothing filter (19).

3. AGC device according to claim 1 characterised in that said third means include a digital multiplier-accumulator (22) and a cascade (28) of switched attenuators controlled by the respective bits of each digital signal leaving said multiplier-accumulator (22).

4. AGC device according to claim 3 characterised in that the attenuations of the attenuators of the cascade (28) vary (from I0 to In) with the respective binary weights of the bits respectively associated with them.

Fig.1

Fig.2